# EUROPEAN PATENT SPECIFICATION

(11) **EP 0 315 387 B1**
(45) Date of publication and mention of the grant of the patent: **13.03.1996**
(21) Application number: 88310200.6
(22) Date of filing: 31.10.1988
(51) Int. Cl.: H01L 21/225, H01S 3/19

(54) **Method of diffusing Si into compound semiconductor and compound semiconductor device**
Verfahren zur Diffusion von Si in einen zusammengesetzten Halbleiter und Verbund-Halbleitervorrichtung
Méthode pour la diffusion de Si dans un semi-conducteur composé et dispositif à semi-conducteur composé

(30) Priority: 04.11.1987 JP 278530/87
(43) Date of publication of application: 10.05.1989
(73) Proprietor: MITSUBISHI DENKI KABUSHIKI KAISHA, Tokyo 100 (JP)
(72) Inventor: Murakami, Takashi c/o Mitsubishi Denki, Mizuhara 4-chome Itami-shi Hyogo-ken (JP)
(74) Representative: Beresford, Keith Denis Lewis

(56) References cited:
- EP-A- 0 225 772
- APPLIED PHYSICS LETTERS, vol. 50, no. 5, 2nd February 1987, pages 265-266,American Institute of Physics, New York, NY, US; E. OMURA et al.: "Silicondiffusion into AlxGa1-xAs(x=0-0.4) from a sputtered silicon film"
- PATENT ABSTRACTS OF JAPAN, vol. 8, no. 39 (E-228)[1476], 21st February 1984;& JP-A-58 197 786 (HITACHI SEISAKUSHO K.K.) 17-11-1983
- JAPANESE JOURNAL OF APPLIED PHYSICS; SUPPLEMENTS (18TH INT. CONF. ON SOLIDSTATE DEVICES AND MATERIALS, Tokyo 1986), 20th-22nd August 1986, pages 141-144,Tokyo, JP; E. OMURA et al.: "Selective double diffusion of Zn and Si into GaAsusing sputtered Si masks"

## Description

### FIELD OF THE INVENTION

The present invention relates to a method of diffusing Si into compound semiconductor and compound semiconductor device, and more particularly to that capable of controlling the diffusion depth at high reproducibility and high precision.

### BACKGROUND OF THE INVENTION

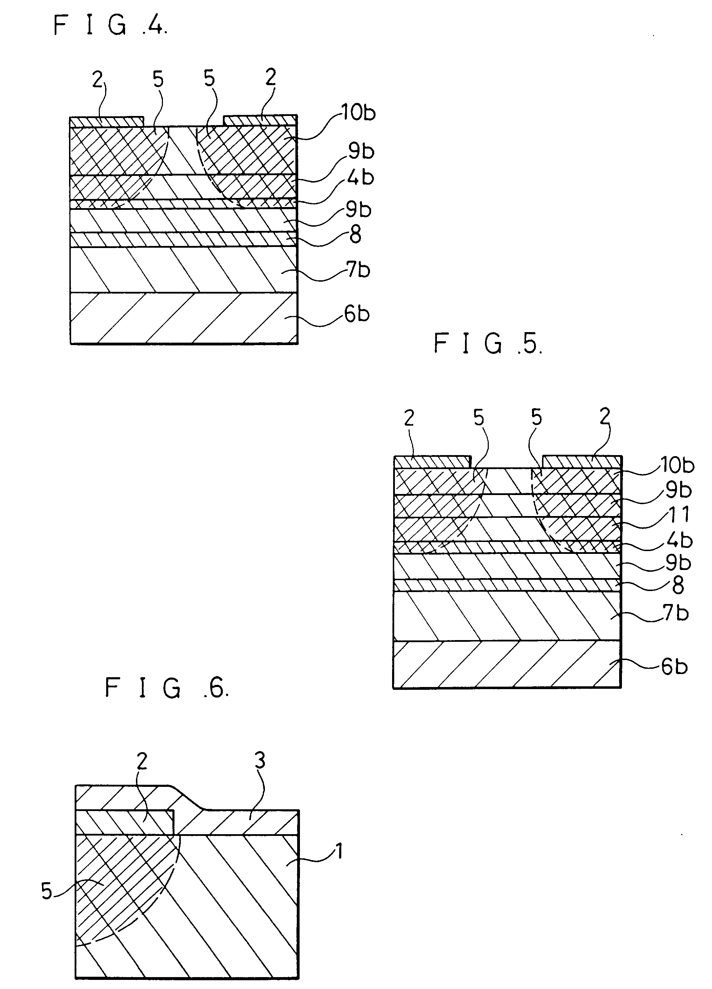

Figure 6 shows a cross-sectional view of a wafer for explaining a prior art method of diffusing Si. In figure 6, reference numeral 1 designates AlₓGa₁₋ₓAs layer (0 ≦ x < 1) as a III - V group compound semiconductor layer. A Si film 2 is provided on a surface of the AlₓGa₁₋ₓAs layer 1 by such as a vacuum evaporation method, a CVD method (Chemical Vapor Deposition), or a sputtering method. A protection layer 3 comprising such as SiO₂ or Si₃N₄ is one for protecting the surfaces of AlₓGa₁₋ₓAs layer 1 and the Si film 2. Si diffusion may be conducted without providing this protection layer 3. Reference numeral 5 designates a Si diffusion region.

The diffusion process will be described.

The AlₓGa₁₋ₓAs layer 1 having Si film 2 thereon is heated up to a temperature of about 800 to 950 °C in arsenide ambient having arsenic partial pressure of about 3.3775 x 10⁵ N/m (0.3 atmosphere). Then, Si is diffused into the Al_{X}Ga_{1-X}AS layer 1 by heating the Si film 2 in arsenide ambient.

A method of this kind is known from Applied Physics Letters, vol.50, no.5, 2 February 1987, pp.265-266.

In this prior art diffusion method, diffusion time, diffusion temperature, arsenic pressure, Si film thickness, protection layer thickness, and material of protection layer can be selected as desired, as parameters which determine the diffusion speed and diffusion depth. For example, as the diffusion temperature is low, arsenic pressure is low, Si film is thick, and protection layer is thick, the diffusion speed is low. The reason why the diffusion speed is low as the protection layer is thick, is described in "1986 International Conference on Solid State Devices and Materials, pp 41 to 44". Since the annealing is conducted in As ambient, As diffuses through the protection layer to reach the interface between the protection layer and GaAs layer, thereby creating an As rich (that is, Ga vacancies rich) region in GaAs layer, and Si will diffuse in association with these vacancies, thereby promoting the diffusion. When the protection layer is thick, As slowly reaches the interface, thereby lowering the diffusion speed.

Furthermore, it is reported in "Appl. Phys. Lett. 44(8), 15 April 1984, pp 750 to 752" and "J. Electrochem. Soc. 129, No. 4, 1982, pp 837 to 840" that the diffusion speed is lower when using a Si₃N₄ protection layer than when using a SiO₂ protection layer. When SiO₂ protection layer is used, Ga in the GaAs layer is likely to diffuse into SiO₂ at the SiO₂ protection and GaAs layer interface during annealing. Thus, Ga vacancies will occur in the GaAs layer and Si will diffuse in association with these vacancies, thereby promoting the diffusion. On the other hand, when Si₃N₄ protection layer is used, Ga is not likely to diffuse into Si₃N₄. In addition, since annealing is conducted in As ambient, As will diffuse through the protection layer to reach the SiO₂ protection and GaAs layer interface, thereby creating an As rich region in GaAs layer, and Si will diffuse in association with these vacancies, thereby promoting the diffusion. In more dense Si₃N₄ film than SiO₂, As slowly reaches the interface, thereby reducing the diffusion speed.

When the Si diffusion process is employed in a device, the diffusion depth needs to be precisely controlled. In the prior art diffusion method, however, since the diffusion depth varies dependent on a lot of parameters as described above, it is difficult to control the diffusion depth at high reproducibility and high precision with suppressing variations of these parameters.

Patent Abstracts of Japan, vol.8, no.39, (E-228) [1476], 21 February 1984 & JP-A-58 197 786 discloses a method of diffusing Zn into a compound semiconductor wherein the diffusion is conducted with providing a diffusion control layer at a position of predetermined depth from the surface of the compound semiconductor.

### SUMMARY OF THE INVENTION

According to the present invention there is provided a method of diffusing Si into a compound semiconductor comprising:
diffusing from a Si film provided on a surface region of said compound semiconductor into said compound semiconductor, said compound semiconductor being AlₓGa₁₋ₓAs, (0 ≤ x < 1);
providing a diffusion stopper layer at a predetermined depth from the surface of said compound semiconductor;
the stopper layer having a lower diffusion speed than that of said compound semiconductor,
the stopper layer comprises Al_{Y}Ga_{1-Y}As (1>y ≧ x+0.3) and has a thickness of about 0.1 µm.

According to the present invention there is provided a compound semiconductor device comprising a compound semiconductor substrate;
a diffusion stopper layer provided on the semiconductor substrate,
a compound semiconductor layer provided on the diffusion stopper layer;
a Si film provided on the semiconductor layer; and
Si diffusion regions extending from the Si film to the interface between the diffusion stopper layer and the semiconductor substrate,
the stopper layer comprising Al_{Y}Ga_{1-Y}As (1 > y ≥ x+0.3), (0 ≤ x < 1) and having a thickness of about 0.1 µm.

According to the present invention there is provided a laser diode comprising:
a substrate made of a first conductivity type compound semiconductor;
a lower cladding layer having itself upper and lower portions being provided on the semiconductor substrate and being made of the first conductivity type compound semiconductor;
a diffusion stopper layer made of the first conductivity type compound semiconductor and being located between the upper and lower portions of the lower cladding layer;
an active layer made of the first conductivity type compound semiconductor provided on the upper portion of the lower cladding layer;
an upper cladding layer provided on the active layer and being made of a second conductivity type compound semiconductor;
a contact layer provided on the upper cladding layer and made of the second conductivity type semiconductor;
Si films provided on the contact layer;
Si diffusion regions extending from the Si films to the interface between the diffusion stopper layer and the lower portion of the lower cladding layer, wherein the stopper layer comprises Al_{Y}Ga_{1-Y}As (1>y ≥ x+0.3), (0 ≤ x < 1), and has a thickness of about 0.1 um.

According to the present invention there is provided a laser diode comprising:
a substrate made of a second conductivity type compound semiconductor;
a lower cladding layer provided on the semiconductor substrate and being made of the second conductivity type compound semiconductor;
an active layer provided on the lower cladding layer and being made of a first conductivity type compound semiconductor;
an upper cladding layer having upper and lower portions being provided on the active layer and being made of the first conductivity type compound semiconductor;
a diffusion stopper layer being located between the upper and lower portions of the upper cladding layer and being made of the first conductivity type compound semiconductor;
a contact layer being provided on the upper portion of the upper cladding layer and being made of the first conductivity type compound semiconductor;
Si films provided on the contact layer; and
Si diffusion regions extending from the Si films to to the interface between the diffusion stopper layer and the lower portion of the upper cladding layer, wherein the stopper layer comprises Al_{Y} Ga_{1-y}As (1>y ≥ x+0.3), (0 ≤ x < 1) and has a thickness of about 0.1 µm.

### BRIEF DESCRIPTION OF THE DRAWINGS

Figures 1(a) and (b) are diagrams showing cross-sectional view of a wafer for explaining a method of diffusing Si according to a first embodiment of the present invention;
Figure 2 is a graph diagram showing Al concentration vs diffusion depth characteristics according to the present invention;
Figures 3, 4 and 5 are diagrams showing cross-sectional views of laser diodes according to a second, a third and a fourth embodiment of the present invention respectively; and
Figure 6 is a diagram showing a cross-sectional view of a wafer for explaining a method of diffusing Si according to the prior art.

### DETAILED DESCRIPTION OF PREFERRED EMBODIMENTS

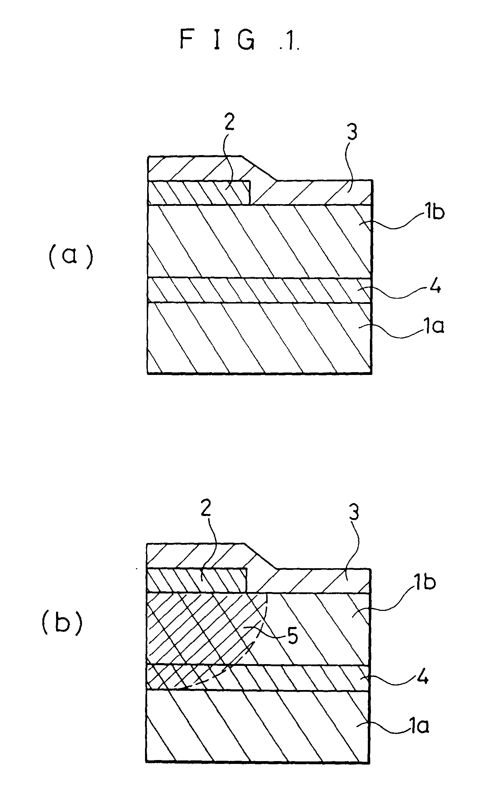

Figures 1(a) and (b) show cross-sectional views for explaining a method of diffusing Si according to a first arrangement. Figure 1(a) shows a cross-sectional view of a wafer in a state prior to Si diffusion and Figure 1(b) shows the wafer in which Si diffusion is conducted.

In Figures 1(a) and (b), reference numerals 1a and 1b designate an Al_{X}Ga_{1-X}As substrate and an Al_{X}Ga_{1 X}As layer, respectively, as III-V group compound semiconductor layers. A Si film 2 is provided on the Al_{X}Ga_{1-X}Ga layer 1b. A protection layer 3 is one for protecting the surfaces of the Al_{X}Ga_{1-X}As layer 1b and the Si film 2. A diffusion stopper layer 4 comprising Al_{Y}Ga_{1-y}As (y > x) is provided at a position of predetermined depth from the surface of the Al_{X}Ga_{1-X}As layer 1b, which stopper layer has a lower diffusion speed than that of the Al_{X}Ga_{1-X}As layer 1b. Reference numeral 5 designates a Si diffusion region.

The diffusion process will be described.

Si diffusion is generally carried out in a closed quartz ampul in which arsenic partial pressure is applied by metal arsenide, or in an opened quartz ampul wherein arsenic partial pressure is applied by injecting arsine (AsH₃). Here, the former process is employed. GaAs is employed as a sample, and the protection layer 3 is omitted. Si film 2 is deposited on the GaAs substrate to a thickness of 300 x 10-¹nm (300 Å) by vacuum evaporation method.

The wafer and metal arsenide are set in the quartz ampul, and the quartz ampul is evacuated and closed. The weight of metal arsenide is about 40 mg per ampul capacity of 40 cc. The quartz ampul is put in the diffusion furnace and diffusion is conducted at a temperature of 850 °C in arsenide ambient having arsenic partial pressure of about 3.3775 x 10⁵ N/m (0.3 atmosphere).

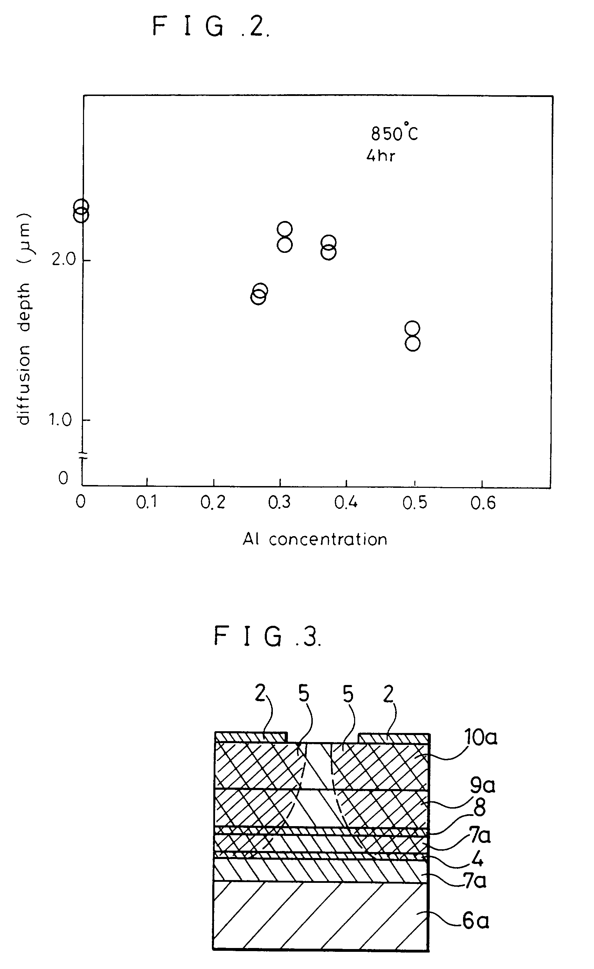

As previously described, diffusion depth varies dependent on Si film thickness, arsenic pressure, and temperature. When diffusion is carried out for four hours under the above described condition, Si is diffused up to a depth of 2.3 µm. On the other hand, when diffusion is carried out into Al_{0.5}Ga_{0.5}As substrate under the same condition as above, Si is diffused up to a depth of only 1.5 µm. Figure 2 is a graph diagram showing Al concentration vs. diffusion depth characteristics. As is apparent from figure 2, as the Al concentration is high, the diffusion depth is shallow, meaning lower diffusion speed.

Suppose that diffusion depth is set to 2.3 µm, the diffusion stopper layer 4 of 0.3 µm, comprising Al_{Y}Ga_{1-Y}As (y ≧ 0.3) is provided at a little above the diffusion front, (for example, at a position of 2.0 µm depth), diffusion can be easily stopped in the stopper layer 4. This means that even if a little variation occurs in the Si film thickness, arsenic partial pressure, and diffusion temperature, diffusion up to a predetermined depth is realized by only conducting diffusion a little longer than usual, without unfavorable effects.

While in the above-illustrated embodiment the process of Si diffusion into a GaAs layer as discussed, Si diffusion into Al_{X}Ga_{1-X}As layer will be carried out by a similar process to that discussed above. In this case the diffusion depth can be easily controlled by providing a diffusion stopper layer 4 comprising Al_{Y}Ga_{1-Y}As (1>y ≧ x + 0.3).

Figure 3 shows a cross-sectional view of a laser diode as a first embodiment of the present invention, wherein a Si diffusion method of the present invention is employed. In figure 3, reference numeral 6a designates a p type GaAs substrate. A p type Al_{0.42}Ga_{0.58}As (or Al_{0.33}Ga_{0.67}As) lower cladding layer 7a is provided on the substrate 6a. A diffusion stopper layer 4 of about 0.1 µm, comprising p type Al_{0.72}Ga_{0.28}As (or Al_{0.63}Ga_{0.37}As) is provided at a position of 0.5 to 1 µm distance from an active layer 8 and between upper and lower portions of the lower cladding layer 7a. A p type Al_{0.08}Ga_{0.92}As (or GaAs) active layer 8 is provided on the upper portion of the lower cladding layer 7a. An n type Al_{0.42}Ga_{0.58}As (or Al_{0.33}Ga_{0.67}As) upper cladding layer 9a is provided on the active layer 8. An n type GaAs contact layer 10a is provided on the upper cladding layer 9a. Si films 2 are provided on the contact layer 10a. Reference numeral 5 designates Si diffusion regions.

In this laser diode, since the diffusion stopper layer 4 is provided at a position lower than the active layer 8, the Si diffusion portion in the active layer 8 becomes to have a lower refractive index than that of the other region in the active layer 8, thereby producing a light waveguide mechanism.

Figure 4 shows a cross-sectional view of a laser diode as a second embodiment of the present invention, wherein the Si diffusion method of the present invention is employed. In figure 4, reference numeral 6b designates an n type GaAs substrate. An n type Al_{0.42}Ga_{0.58}As (or Al_{0.33}Ga_{0.67}As) lower cladding layer 7b is provided on the substrate 6b. A p type Al_{0.08}Ga_{0.92}As (or GaAs) active layer 8 is provided on the lower cladding layer 7b. A p type Al_{0.42}Ga_{0.58}As (or Al_{0.33}Ga_{0.67}As) upper cladding layer 9b is provided on the active layer 8. A diffusion stopper layer 4b of about 0.1 µm, which comprises Al_{0.72}Ga_{0.28}As (or Al_{0.63}Ga_{0.37}As) is provided at a position of 0.2 to 0.3 µm distance from the active layer 8 and between the upper and lower portions of the upper cladding layer 9b. A p type GaAs contact layer 10b is provided on the upper portion of the upper cladding layer 9b.

In this laser diode, the transverse mode is controlled by the Si diffusion. When Si diffusion is carried out, the Si diffusion portion in the upper cladding layer 9b and the diffusion stopper layer 4b comes to have a lower refractive index than that of the other portions of the cladding layer 9b and the stopper layer 4b. When the portions of high refractive index and low refractive index exist near the active layer, the active layer 8 comes to have aneffective refractive index distribution in the transverse direction, thereby confining the light in the center of the laser chip. Accordingly, the transverse mode can be controlled by controlling the diffusion depth, and the longitudinal direction mode can be further controlled. As discussed above, the distance between the diffusion front and the active layer greatly affects the laser diode characteristics, meaning the importance of the control of diffusion depth. Thus, the present invention can be effectively utilized.

Figure 5 shows a cross-sectional view of a laser diode which further comprises a lightguide layer 11 in the device as shown in figure 4. In this laser diode, the lightguide layer 11 comprises an A1GaAs series superlattice and is provided between the diffusion stopper layer 4b and the upper cladding layer 9b. The superlattice is disordered in the Si diffusion region 5, and becomes a mixed crystal of single composition. Since the portion of mixed crystal has a refractive index which is different from that of the portion of superlattice, a light waveguide mechanism is produced. In this structure, the diffusion stopper layer 4 is provided under the light guide layer 11, and the Si diffusion is precisely stopped in the stopper layer 4, thereby obtaining a laser diode with high reproducibility and uniform characteristics.

As discussed above, according to the present invention, Si diffusion into compound semiconductor is conducted to provide a diffusion stopper layer at a position of predetermined depth from the surface of the compound semiconductor, which stopper layer has a lower diffusion speed than that of the compound semiconductor. Thus, the diffusion depth can be controlled at high reproducibility and high precision.

## Claims

1. A method of diffusing Si into a compound semiconductor comprising:
diffusing from a Si film provided on a surface region of said compound semiconductor into said compound semiconductor, said compound semiconductor being AlₓGa₁₋ₓAs, (0 ≤ x < 1);
providing a diffusion stopper layer (4) at a predetermined depth from the surface of said compound semiconductor;
the stopper layer (4) having a lower diffusion speed than that of said compound semiconductor,
the stopper layer (4) comprising Al_{Y}Ga_{1-Y} As (1 > y ≧ x+0.3) and having a thickness of about 0.1 µm.

2. A compound semiconductor device comprising:
a compound semiconductor substrate (1a);
a diffusion stopper layer (4) provided on the semiconductor substrate (1a),
a compound semiconductor layer (1b) provided on the diffusion stopper layer (4);
a Si film (2) provided on the semiconductor layer (1b); and
Si diffusion regions (5) extending from the Si film (2) to the interface between the diffusion stopper layer (4) and the semiconductor substrate (1a),
the stopper layer (4) comprising Al_{Y}Ga_{1-Y}AS (1 >y ≧ x+0.3), (0 ≤ x < 1) and having a thickness of about 0.1 µm.

3. A laser diode comprising:
a substrate (6a) made of a first conductivity type compound semiconductor;
a lower cladding layer (7a) having itself upper and lower portions being provided on the semiconductor substrate (6a) and being made of the first conductivity type compound semiconductor;
a diffusion stopper layer (4) made of the first conductivity type compound semiconductor and being located between the upper and lower portions of the lower cladding layer (7a);
an active layer (8) made of the first conductivity type compound semiconductor provided on the upper portion of the lower cladding layer (7a);
an upper cladding layer (9a) provided on the active layer (8) and being made of a second conductivity type compound semiconductor;
a contact layer (10a) provided on the upper cladding layer (9a) and made of the second conductivity type semiconductor;
Si films (2) provided on the contact layer (10a);
Si diffusion regions (5) extending from the Si films (2) to the interface between the diffusion stopper layer (4) and the lower portion of the lower cladding layer (7a), wherein the stopper layer (4) comprises Al_{y}Ga₁*₋*_{y}As(1>y ≥ x+0.3), (0 ≤ x < 1), and has a thickness of about 0.1 µm.

4. A laser diode utilising a compound semiconductor as defined in claim 3, wherein said semiconductor substrate (6a) comprises p type GaAs, said lower cladding layer (7a) comprises p type Al_{Z}Ga_{1-z}As, said diffusion stopper layer (4) comprises p type Al_{Y}Ga_{1-Y}As(y > z), said active layer (8) comprises p type Al_{W}Ga_{1-w}As, (w=0 or 0.08) said upper cladding layer (9a) comprises n type Al_{Z}Ga_{1-z}As, and said contact laye (10a) comprises n type GaAs.

5. A laser diode comprising:
a substrate (6b) made of a second conductivity type compound semiconductor;
a lower cladding layer (7b) provided on the semiconductor substrate (6b) and being made of the second conductivity type compound semiconductor;
an active layer (8) provided on the lower cladding layer (7b) and being made of a first conductivity type compound semiconductor;
an upper cladding layer (9b) having upper and lower portions being provided on the active layer (8) and being made of the first conductivity type compound semiconductor;
a diffusion stopper layer (4b) being located between the upper and lower portions of the upper cladding layer (9b) and being made of the first conductivity type compound semiconductor;
a contact layer (10b) being provided on the upper portion of the upper cladding layer (9b) and being made of the first conductivity type compound semiconductor;
Si films (2) provided on the contact layer (10b); and
Si diffusion regions (5) extending from the Si films (2) to the interface between the diffusion stopper layer (4b) and the lower portion of the upper cladding layer (9b), wherein the stopper layer (4) comprises Al_{Y}Ga_{1-y}As (1 > y ≥ x+0.3), (0 ≤ x < 1) and has a thickness of about 0.1 µm.

6. A laser diode utilising a compound semiconductor as defined in claim 5, wherein said semiconductor substrate (6b) comprises n type GaAs, said lower cladding layer (7b) comprises n type Al_{z}Ga_{1-z}As, said active layer (8) comprises p type Al_{w}Ga_{1-w}As, (w = 0 or 0.08) said upper cladding layer (9b) comprises p type Al_{z}Ga_{1-z}As, said diffusion stopper layer (4b) comprises p type Al_{Y}Ga_{1-Y}As (y > z), and said contact layer (10b) comprises p type GaAs.

7. A laser diode utilising a compound semiconductor as defined in claim 5 or claim 6, which further comprises a light guide layer (11) provided between said diffusion stopper layer (4b) and said upper portion of said upper cladding layer (9b).

8. A laser diode utilising a compound semiconductor as defined in claim 7, wherein said semiconductor substrate (6b) comprises n type GaAs, said lower cladding layer (7b) comprises n type Al_{z}Ga_{1-z}As, said active layer (8) comprises p type Al_{w}Ga_{1-w} As, (w = 0 or 0.08) said upper cladding layer (9b) comprises p type Al_{z}Ga_{1-z}As, said diffusion stopper layer (4b) comprises p type Al_{y}Ga_{1-y}As (y > z), said contact layer (10b) comprises p type GaAs, and said light guide layer (11) comprises AlGaAs series superlattice.

## Patentansprüche

1. Verfahren zum Diffundieren von Si in einen Verbindungshalbleiter, das beinhaltet:
das Diffundieren eines Si-Films, der auf einem Oberflächenbereich des Verbindungshalbleiters vorgesehen ist, in den Verbindungshalbleiter, wobei der Verbindungshalbleiter AlₓGa₁₋ₓAs (0≤x<1) ist,
das Vorsehen einer Diffusionssperrschicht (4) bei einer vorbestimmten Tiefe von der Oberfläche des Verbindungshalbleiters aus,
wobei die Sperrschicht (4) eine geringere Diffusionsgeschwindigkeit als der Verbindungshalbleiter hat,
wobei die Sperrschicht (4) Al_{y}Ga_{1-y}As (1>y≥x+0,3) aufweist und eine Dicke von ungefähr 0,1µm hat.

2. Verbindungshalbleitervorrichtung, die aufweist:
ein Verbindungshalbleitersubstrat (1a),
eine Diffusionssperrschicht (4), die auf dem Halbleitersubstrat (1a) vorgesehen ist,
eine Verbindungshalbleiterschicht (1b), die auf der Diffusionssperrschicht (4) vorgesehen ist,
einen Si-Film (2), der auf der Halbleiterschicht (1b) vorgesehen ist, und
Si-Diffusionsbereiche (5), die sich vom Si-Film (2) zur Grenzfläche zwischen der Diffusionssperrschicht (4) und dem Halbleitersubstrat (1a) erstrecken,
wobei die Sperrschicht (4) Al_{y}Ga_{1-y}As (1>y≥x+0,3), (0≤x<1) aufweist und eine Dicke von ungefähr 0,1µm hat.

3. Laserdiode, die aufweist:
ein Substrat (6a), das aus einem Verbindungshalbleiter vom ersten Leitfähigkeitstyp gefertigt ist,
eine untere Beschichtungslage (7a), die selbst obere und untere Abschnitte hat, auf dem Halbleitersubstrat (6a) vorgesehen ist und aus dem Verbindungshalbleiter vom ersten Leitfähigkeitstyp gefertigt ist,
eine Diffusionssperrschicht (4), die aus dem Verbindungshalbleiter vom ersten Leitfähigkeitstyp gefertigt ist und sich zwischen den oberen und unteren Abschnitten der unteren Beschichtungslage (7a) befindet,
eine aktive Schicht (8), die aus dem Verbindungshalbleiter vom ersten Leitfähigkeitstyp gefertigt ist und auf dem oberen Abschnitt der unteren Beschichtungslage (7a) vorgesehen ist,
eine obere Beschichtungslage (9a), die auf der aktiven Schicht (8) vorgesehen ist und aus einem Verbindungshalbleiter vom zweiten Leitfähigkeitstyp gefertigt ist,
eine Kontaktschicht (10a), die auf der oberen Beschichtungslage (9a) vorgesehen ist und aus dem Halbleiter vom zweiten Leitfähigkeitstyp gefertigt ist,
Si-Filme (2), die auf der Kontaktschicht (10a) vorgesehen sind,
Si-Diffusionsbereiche (5), die sich von den Si-Filmen (2) aus zur Grenzfläche zwischen der Diffusionssperrschicht (4) und dem unteren Abschnitt der unteren Beschichtungslage (7a) erstrecken, wobei die Sperrschicht (4) Al_{y}Ga_{1-y}As (1>y≥x+0,3), (0≤x<1) aufweist und eine Dicke von ungefähr 0,1µm hat.

4. Laserdiode, die einen Verbindungshalbleiter nach Anspruch 3 verwendet, wobei das Halbleitersubstrat (6a) GaAs vom p-Typ aufweist, die untere Beschichtungslage (7a) Al_{z}Ga_{1-z}As vom p-Typ aufweist, die Diffusionssperrschicht (4) Al_{y}Ga_{1-y}As (y>z) vom p-Typ aufweist, die aktive Schicht (8) Al_{w}Ga_{1-w}As (w= 0 oder 0,08) vom p-Typ aufweist, die obere Beschichtungslage (9a) Al_{z}Ga_{1-z}As vom n-Typ aufweist und die Kontaktschicht (10a) GaAs vom n-Typ aufweist.

5. Laserdiode, die aufweist:
ein Substrat (6b), das aus einem Verbindungshalbleiter vom zweiten Leitfähigkeitstyp gefertigt ist,
eine untere Beschichtungslage (7b), die auf dem Halbleitersubstrat (6b) vorgesehen ist und aus dem Verbindungshalbleiter vom zweiten Leitfähigkeitstyp gefertigt ist,
eine aktive Schicht (8), die auf der unteren Beschichtungslage (7b) vorgesehen ist und aus einem Verbindungshalbleiter vom ersten Leitfähigkeitstyp gefertigt ist,
eine obere Beschichtungslage (9b), die obere und untere Abschnitte hat, auf der aktiven Schicht (8) vorgesehen ist und aus dem Verbindungshalbleiter vom ersten Leitfähigkeitstyp gefertigt ist,
eine Diffusionssperrschicht (4b), die sich zwischen den oberen und unteren Abschnitten der oberen Beschichtungslage (9b) befindet und aus dem Verbindungshalbleiter vom ersten Leitfähigkeitstyp gefertigt ist,
eine Kontaktschicht (10b), die auf dem oberen Abschnitt der oberen Beschichtungslage (9b) vorgesehen ist und aus dem Verbindungshalbleiter vom ersten Leitfähigkeitstyp gefertigt ist,
Si-Filme (2), die auf der Kontaktschicht (10b) vorgesehen sind, und
Si-Diffusionsbereiche (5), die sich von den Si-Filmen (2) aus zur Grenzfläche zwischen der Diffusionssperrschicht (4b) und dem unteren Abschnitt der oberen Beschichtungslage (9b) erstrecken, wobei die Sperrschicht (4) Al_{y}Ga_{1-y}As (1>y≥x+0,3), (0≤x<1) aufweist und eine Dicke von ungefähr 0,1µm hat.

6. Laserdiode, die einen Verbindungshalbleiter nach Anspruch 5 verwendet, wobei das Halbleitersubstrat (6b) GaAs vom n-Typ aufweist, die untere Beschichtungslage (7b) Al_{z}Ga_{1-z}As vom n-Typ aufweist, die aktive Schicht (8) Al_{w}Ga_{1-w}As (w=0 oder 0,08) vom p-Typ aufweist, die obere Beschichtungslage (9b) Al_{z}Ga_{1-z}As vom p-Typ aufweist, die Diffusionssperrschicht (4b) Al_{y}Ga_{1-y}As (y>z) vom p-Typ aufweist und die Kontaktschicht (10b) GaAs vom p-Typ aufweist.

7. Laserdiode, die einen Verbindungshalbleiter nach Anspruch 5 oder 6 verwendet und ferner eine Lichtleiterschicht (11) aufweist, die zwischen der Diffusionssperrschicht (4b) und dem oberen Abschnitt der oberen Beschichtungslage (9b) vorgesehen ist.

8. Laserdiode, die einen Verbindungshalbleiter nach Anspruch 7 verwendet, wobei das Halbleitersubstrat (6b) GaAs vom n-Typ aufweist, die untere Beschichtungslage (7b) Al_{z}Ga_{1-z}As vom n-Typ aufweist, die aktive Schicht (8) Al_{w}Ga_{1-w}As (w=0 oder 0,08) vom p-Typ aufweist, die obere Beschichtungslage (9b) Al_{z}Ga_{1-z}As vom p-Typ aufweist, die Diffusionssperrschicht (4b) Al_{y}Ga_{1-y}As (y>z) vom p-Typ aufweist, die Kontaktschicht (10b) GaAs vom p-Typ aufweist und die Lichtleiterschicht (11) AlGaAs Reihenübergitter aufweist.

## Revendications

1. Méthode de diffusion de Si dans un semi-conducteur composé consistant à :
diffuser, d'un film de Si prévu sur une région de surface dudit semi-conducteur composé, dans ledit semi-conducteur composé, ledit semi-conducteur composé étant Al_{X}Ga₁₋ₓAs, (0 ≤ X < 1) ;
prévoir une couche d'arrêt de diffusion (4) en une profondeur prédéterminée à partir de la surface dudit semi-conducteur composé ;
la couche d'arrêt (4) ayant une plus faible vitesse de diffusion que celle dudit semi-conducteur composé ;
la couche d'arrêt (4) comprenant Al_{y}Ga_{1-y}As (1 > y ≥ x + 0,3) et ayant une épaisseur d'environ 0,1 µm.

2. Dispositif à semi-conducteur composé comprenant :
un substrat semi-conducteur composé (1a) ;
une couche d'arrêt de diffusion (4) prévue sur le substrat semi-conducteur (1a) ;
une couche d'un semi-conducteur composé (1b) prévue sur la couche d'arrêt de diffusion (4) ;
un film en Si (2) prévu sur la couche de semi-conducteur (1b) ; et
des régions de diffusion de Si (5) s'étendant à partir du film de Si (2) jusqu'à l'interface entre la couche d'arrêt de diffusion (4) et le substrat semi-conducteur (1a) ;
la couche d'arrêt (4) comprenant Al_{y}Ga_{1-y}As (1 > y ≥ x + 0,3), (0 ≤ x < 1) et ayant une épaisseur d'environ 0,1 µm.

3. Diode laser comprenant :
un substrat (6a) fait d'un semi-conducteur composé d'un premier type de conductivité ;
une couche inférieure de placage (7a) ayant elle-même des portions supérieure et inférieure qui est prévue sur le substrat semi-conducteur (6a) et qui est faite du semi-conducteur composé du premier type de conductivité ;
une couche d'arrêt de diffusion (4) faite du semi-conducteur composé du premier type de conductivité et qui est placée entre les portions supérieure et inférieure de la couche inférieure de placage (7a) ;
une couche active (8) faite du semi-conducteur composé du premier type de conductivité prévue sur la portion supérieure de la couche inférieure de placage (7a) ;
une couche supérieure de placage (9a) prévue sur la couche active (8) et qui est faite d'un semi-conducteur composé d'un second type de conductivité ;
une couche de contact (10a) prévue sur la couche supérieure de placage (9a) et faite du semi-conducteur du second type de conductivité ;
des films de Si (2) prévus sur la couche de contact (10a) ;
des régions de diffusion de Si (5) s'étendant à partir des films de Si (2) jusqu'à l'interface entre la couche d'arrêt de diffusion (4) et la portion inférieure de la couche inférieure de placage (7a), où la couche d'arrêt (4) comprend Al_{y}Ga_{1-y}As (1 > y ≥ x + 0,3), (0 ≤ x < 1), et a une épaisseur d'environ 0,1 µm.

4. Diode laser utilisant un semi-conducteur composé tel que défini à la revendication 3 où ledit semi-conducteur composé (6a) comprend GaAs du type p, ladite couche inférieure de placage (7a) comprend Al_{z}Ga_{1-z}As du type p, ladite couche d'arrêt de diffusion (4) comprend Al_{y}Ga_{1-y}As du type p (y > z), ladite couche active (8) comprend Al_{w}Ga_{1-w}As, (w = 0 ou 0,08), ladite couche supérieure de placage (9a) comprend Al_{z}Ga_{1-z}As du type n et ladite couche de contact (10a) comprend GaAs du type n.

5. Diode laser comprenant :
un substrat (6b) fait d'un semi-conducteur composé d'un second type de conductivité ;
une couche inférieure de placage (7b) prévue sur le substrat semi-conducteur (6b) et qui est faite du semi-conducteur composé du second type de conductivité ;
une couche active (8) prévue sur la couche inférieure de placage (7b) et qui est faite d'un semi-conducteur composé d'un premier type de conductivité ;
une couche supérieure de placage (9b) ayant des portions supérieure et inférieure qui est prévue sur la couche active (8) et qui est faite du semi-conducteur composé du premier type de conductivité ;
une couche d'arrêt de diffusion (4b) placée entre les portions supérieure et inférieure de la couche supérieure de placage (9b) et qui est faite du semi-conducteur composé du premier type de conductivité ;
une couche de contact (10b) prévue sur la portion supérieure de la couche supérieure de placage (9b) et qui est faite du semi-conducteur composé du premier type de conductivité ;
des films de Si (2) prévus sur la couche de contact (10b) ; et
des régions de diffusion de Si (5) s'étendant à partir des films de Si (2) jusqu'à l'interface entre la couche d'arrêt de diffusion (4b) et la portion inférieure de la couche supérieure de placage (9b), où la couche d'arrêt (4) comprend Al_{y}Ga_{1-y}As (1 > y ≥ x + 0,3), (0 ≤ x < 1) et a une épaisseur d'environ 0,1 µm.

6. Diode laser utilisant un semi-conducteur composé tel que défini à la revendication 5 où ledit substrat semi-conducteur (6b) comprend GaAs du type n, ladite couche inférieure de placage (7b) comprend Al_{z}Ga_{1-z}As du type n, ladite couche active (8) comprend Al_{w}Ga_{1-w}As du type p, (w = 0 ou 0,08), ladite couche supérieure de placage (9b) comprend Al_{z}Ga_{1-z}As du type p, ladite couche d'arrêt de diffusion (4b) comprend Al_{y}Ga_{1-y}As du type p (y > z), et ladite couche de contact (10b) comprend GaAs du type p.

7. Diode laser utilisant un semi-conducteur composé tel que défini à la revendication 5 ou la revendication 6 qui comprend de plus une couche de guide de la lumière (11) prévue entre ladite couche d'arrêt de diffusion (4b) et ladite portion supérieure de ladite couche supérieure de placage (9b).

8. Diode laser utilisant un semi-conducteur composé tel que défini à la revendication 7 où ledit substrat semi-conducteur (6b) comprend GaAs du type n, ladite couche inférieure de placage (7) comprend Al_{z}Ga_{1-z}As du type n, ladite couche active (8) comprend Al_{w}Ga_{1-w}As du type p (w = 0 ou 0,08), ladite couche supérieure de placage (9b) comprend Al_{z}Ga_{1-z}As du type p, ladite couche d'arrêt de diffusion (4b) comprend Al_{y}Ga_{1-y}As du type p (y > z), ladite couche de contact (10b) comprend GaAs du type p et ladite couche formant guide de la lumière (11) comprend un super-réseau de la série AlGaAs.
